# EUROPEAN PATENT APPLICATION

(11) **EP 4 650 797 A1**
(43) Date of publication of application: **19.11.2025**
(21) Application number: 23916842.0
(22) Date of filing: 20.01.2023
(51) Int. Cl.: G01R 31/28

(54) **TEST DEVICE AND TEST METHOD FOR CHIP**

(71) Applicant: Contemporary Amperex Technology Co., Limited, Ningde, Fujian 352100 (CN)
(72) Inventor: ZHOU, Fangjie, Ningde, Fujian 352100 (CN); WANG, Xingchang, Ningde, Fujian 352100 (CN); LI, Qiandeng, Ningde, Fujian 352100 (CN)
(74) Representative: Gong, Jinping
(86) International application number: PCT/CN2023/073391
(87) International publication number: WO 2024/152364

(57) **Abstract**

Embodiments of the present application provide a chip testing device and a chip testing method. The testing device includes a processor configured to acquire pin connection control information of a target chip, the pin connection control information being used for indicating a sequence of connection between at least some pins of the target chip and a power supply module. The processor is further configured to control the at least some pins to be connected to the power supply module according to the sequence of connection. The testing device and testing method of the embodiments of the present application can improve the efficiency of chip testing.

## Description

### TECHNICAL FIELD

The present application relates to the field of chip testing, and in particular to a chip testing device and a chip testing method.

### BACKGROUND

As chips become more and more complex, accordingly there are increasingly more failure modes, which makes chip testing technology particularly important. Current chip testing solutions still rely mainly on manual testing, which has a low level of intelligence and results in low testing efficiency.

### SUMMARY OF THE INVENTION

The present application provides a chip testing device and a chip testing method, which can improve the chip testing efficiency.

In a first aspect, a chip testing device is provided, including: a processor configured to acquire pin connection control information of a target chip, the pin connection control information being used for indicating a sequence of connection between at least some pins of the target chip and a power supply module; the processor is further configured to control the at least some pins to be connected to the power supply module according to the sequence of connection.

In this embodiment, the processor acquires the pin connection control information of the target chip to control the sequence of connection between the at least some pins of the target chip and the power supply module, thereby realizing intelligent testing of the chip and improving the chip testing efficiency.

In a possible implementation, the power supply module includes a plurality of power supply units, and according to the sequence of connection, the processor is specifically configured to: control the at least some pins to be connected respectively to positive and negative electrodes of at least some of the plurality of power supply units according to the sequence of connection.

In a possible implementation, the at least some power supply units include a first power supply unit and a second power supply unit, and the processor is specifically configured to: control two pins among the at least some pins to be connected respectively to the positive electrode of the first power supply unit and the negative electrode of the second power supply unit according to the sequence of connection, so that the voltage between the two pins is U, where U is a sum of the voltages of the plurality of power supply units.

In this embodiment, two pins among the at least some pins are controlled to be connected respectively to the positive electrode of the first power supply unit and the negative electrode of the second power supply unit according to the sequence of connection, so that the voltage between the two pins is a sum of the voltages of the plurality of power supply units corresponding to the target chip, thereby allowing the target chip to be tested in the working condition where it is most likely to be damaged, which can avoid the release of abnormal chips.

In a possible implementation, the positive electrode of the first power supply unit is the positive electrode of the power supply module, and the negative electrode of the second power supply unit is the negative electrode of the power supply module.

In a possible implementation, the two pins include a power pin and a ground pin of the target chip.

In a possible implementation, the sequence of connection includes: the two pins are first connected to the power supply module.

In this embodiment, by controlling two pins among the at least some pins of the target chip to be connected to the power supply module first, the voltage between the two pins can be made a sum of the voltages of the plurality of power supply units corresponding to the target chip, thereby enabling the target chip to be tested in the working condition where it is most likely to be damaged, which can avoid the release of abnormal chips.

In a possible implementation, the sequence of connection further includes: after the two pins are connected to the power supply module, the pins among the at least some pins except the two pins are connected to the power supply module in a random sequence.

In a possible implementation, the sequence of connection includes: the at least some pins are connected to the power supply module in a random sequence.

In a possible implementation, the pin connection control information is further used for indicating a connection delay between the two pins among the at least some pins that are connected sequentially to the power supply module; and the processor is specifically configured to control the at least some pins to be connected to the power supply module according to the sequence of connection and the connection delay.

In a possible implementation, the connection delay is a random value.

In a possible implementation, the testing device further includes a switch matrix, through which the pins of the target chip are connected to the power supply module, and the pin connection control information is used for indicating a switch closing sequence of the switch matrix.

In this embodiment, since the pins of the target chip are connected to the power supply module through the switch matrix, the switch closing sequence of the switch matrix is acquired, and the switches in the switch matrix are closed sequentially according to the switch closing sequence to control at least some pins of the target chip to be connected to the power supply module, thereby improving the testing flexibility of the target chip.

In a possible implementation, the target chip includes a first target chip and a second target chip, the power supply module includes a first power supply submodule and a second power supply submodule, the switch matrix includes a plurality of first switches, a plurality of second switches, a first connector, a second connector, a third connector and a fourth connector, the first connector is connected to the first power supply submodule, the second connector is connected to the second power supply submodule, the third connector is connected to the first target chip, the fourth connector is connected to the second target chip, the first connector and the third connector are connected through the plurality of first switches, the second connector and the fourth connector are connected through the plurality of second switches, the power pin and the ground pin of the first target chip are connected respectively to the positive electrode and the negative electrode of the first power supply submodule, and the power pin and the ground pin of the second target chip are connected respectively to the positive electrode and the negative electrode of the second power supply submodule.

In a possible implementation, the switch closing sequence includes: two first switches among the plurality of first switches connected to the power pin and the ground pin of the first target chip are closed first, and then the other first switches among the plurality of first switches are randomly closed; and/or two second switches among the second switches connected to the power pin and the ground pin of the second target chip are closed first, and then the other second switches among the plurality of second switches are randomly closed.

In a possible implementation, the switch closing sequence includes: the plurality of first switches are randomly closed, and/or the plurality of second switches are randomly closed.

In a possible implementation, the target chip includes a first target chip or a second target chip, the power supply module includes a first power supply submodule and a second power supply submodule connected in series, the switch matrix includes a plurality of third switches, a first connector, a second connector and a third connector, the first connector is connected to the first power supply submodule, the second connector is connected to the second power supply submodule, the third connector is connected to the first target chip or the second target chip, and the first connector and the second connector are connected to the third connector through the plurality of third switches.

In a possible implementation, the switch closing sequence includes: the some third switches among the plurality of third switches connected to the first connector are closed first, and then the other some third switches among the plurality of third switches connected to the second connector are closed; or the some third switches among the plurality of third switches connected to the second connector are closed first, and then the other some third switches among the plurality of third switches connected to the first connector are closed.

In a possible implementation, the power pin and the ground pin of the first target chip or the second target chip are connected respectively to the positive electrode and the negative electrode of the power supply module; the some third switches include a third switch connected to the power pin of the first target chip or the second target chip, and the other some third switches include a third switch connected to the ground pin of the first target chip or the second target chip, and the switch closing sequence includes: after the some third switches are closed, the third switch among the other some third switches connected to the ground pin of the first target chip or the second target chip is closed first, and then other third switches among the other some third switches are randomly closed; or the some third switches include a third switch connected to the ground pin of the first target chip or the second target chip, and the other some third switches include a third switch connected to the power pin of the first target chip or the second target chip, and the switch closing sequence includes: after the some third switches are closed, the third switch among the other some third switches connected to the power pin of the first target chip or the second target chip is closed first, and then other third switches among the other some third switches are randomly closed.

In a possible implementation, the target chip includes a first target chip and a second target chip, the switch matrix includes a plurality of fourth switches, a plurality of fifth switches, a first connector and a second connector, the first connector is connected to the power supply module, the first target chip and the second target chip are both connected to the second connector, the first connector and the second connector are connected through the plurality of fourth switches and the plurality of fifth switches, the power pin and the ground pin of the first target chip are connected respectively to the positive electrode and the negative electrode of some power supply units in the power supply module, and the power pin and the ground pin of the second target chip are connected respectively to the positive electrode and the negative electrode of the other some power supply units in the power supply module.

In a possible implementation, the switch closing sequence includes: the fourth switch among the plurality of fourth switches connected to the power pin of the first target chip and the fifth switch among the plurality of fifth switches connected to the ground pin of the second target chip are closed first, then the fourth switch among the plurality of fourth switches connected to the ground pin of the first target chip and the fifth switch among the plurality of fifth switches connected to the power pin of the second target chip are closed, and finally the other fourth switches among the plurality of fourth switches and the other fifth switches among the plurality of fifth switches are randomly closed.

In a possible implementation, the switch closing sequence includes: the plurality of fourth switches and the plurality of fifth switches are randomly closed.

In a possible implementation manner, the power pin of the first target chip is connected to the ground pin of the second target chip.

In a possible implementation, the switch closing sequence includes: the plurality of fourth switches are closed first, then the fifth switch among the plurality of fifth switches connected to the power pin of the second target chip is closed, and finally the other fifth switches among the plurality of fifth switches are randomly closed, or the plurality of fifth switches are closed first, then the fourth switch among the plurality of fourth switches connected to the ground pin of the first target chip is closed, and finally the other fourth switches among the plurality of fourth switches are randomly closed.

In a possible implementation, the switch matrix includes a plurality of discharge units, each of the plurality of discharge units is respectively arranged between two pins in the target chip, and the processor is further configured to: before acquiring the pin connection control information of the target chip, control the plurality of discharge units to discharge a peripheral circuit of the target chip.

In a possible implementation, one discharge unit is arranged between every two adjacent pins of the target chip.

In a possible implementation, one discharge unit is arranged between each of the pins of the target chip except the ground pin and the ground pin.

In a possible implementation, the discharge unit includes a discharge switch and a resistor connected in series with the discharge switch, and the processor is specifically configured to: control the discharge switch in each of the plurality of discharge units to be closed to discharge the peripheral circuit of the target chip.

Optionally, the testing device can be configured to perform a hot-swap test on the target chip.

In this embodiment, a plurality of discharge units are arranged in the switch matrix to discharge the peripheral circuit of the target chip after each hot-swap test is completed, to ensure that each hot-swap test is in the same initial state, thereby avoiding the problem that the target chip is partially charged after the first hot-swap test, resulting in increasingly weaker subsequent hot-swap stress, which causes the test to be in vain. Besides, adding discharge units can also make each test of the target chip closer to the actual situation, thereby improving the accuracy of the test.

In a possible implementation, the processor is specifically configured to: control the at least some pins to be connected to the power supply module a plurality of times according to a preset number of times based on the sequence of connection.

In this embodiment, the test is repeated a plurality of times in the same working condition to improve the credibility of the test.

Optionally, the preset number is greater than or equal to 30.

In a possible implementation, the processor is further configured to: after controlling the at least some pins to be connected to the power supply module a plurality of times according to the preset number of times based on the sequence of connection, verify the function of the target chip.

Optionally, the processor may further be configured to: in the process of controlling the at least some pins to be connected to the power supply module according to the sequence of connection, confirm whether the circuit function of the target chip is normal according to the reported information from the target chip.

In a possible implementation, the target chip is an analog front end AFE chip.

In this embodiment, a hot-swap test of the AFE chip is performed at the AFE chip design end, which can avoid the release of abnormal AFE chips, thereby reducing terminal application losses, speeding up the design and application of the terminal, and promoting the healthy development of the new energy industry.

In a second aspect, a chip testing method is provided, including: acquiring pin connection control information of a target chip, the pin connection control information being used for indicating a sequence of connection between at least some pins of the target chip and a power supply module; and controlling the at least some pins to be connected to the power supply module according to the sequence of connection.

In a possible implementation, the power supply module includes a plurality of power supply units, and controlling the at least some pins to be connected to the power supply module according to the sequence of connection includes: controlling the at least some pins to be connected respectively to positive and negative electrodes of at least some of the plurality of power supply units according to the sequence of connection.

In a possible implementation, the at least some power supply units include a first power supply unit and a second power supply unit, and controlling the at least some pins to be connected respectively to positive and negative electrodes of at least some of the plurality of power supply units according to the sequence of connection includes: controlling two pins among the at least some pins to be connected respectively to the positive electrode of the first power supply unit and the negative electrode of the second power supply unit according to the sequence of connection, so that the voltage between the two pins is U, where U is a sum of the voltages of the plurality of power supply units.

In a possible implementation, the positive electrode of the first power supply unit is the positive electrode of the power supply module, and the negative electrode of the second power supply unit is the negative electrode of the power supply module.

In a possible implementation, the two pins include a power pin and a ground pin of the target chip.

In a possible implementation, the sequence of connection includes: the two pins are first connected to the power supply module.

In a possible implementation, the sequence of connection further includes: after the two pins are connected to the power supply module, the pins among the at least some pins except the two pins are connected to the power supply module in a random sequence.

In a possible implementation, the sequence of connection includes: the at least some pins are connected to the power supply module in a random sequence.

In a possible implementation, the pin connection control information is further used for indicating a connection delay between the two pins among the at least some pins that are connected sequentially to the power supply module; and the controlling the at least some pins to be connected to the power supply module includes: controlling the at least some pins to be connected to the power supply module according to the sequence of connection and the connection delay.

In a possible implementation, the pins of the target chip are connected to the power supply module through the switch matrix, and the pin connection control information is used for indicating a switch closing sequence of the switch matrix.

In a possible implementation, the switch matrix includes a plurality of discharge units, each of the plurality of discharge units is respectively arranged between two pins in the target chip, and the testing method further includes: before acquiring the pin connection control information of the target chip, controlling the plurality of discharge units to discharge a peripheral circuit of the target chip.

In a possible implementation, the discharge unit includes a discharge switch and a resistor connected in series with the discharge switch, and the controlling the plurality of discharge units to discharge a peripheral circuit of the target chip includes: controlling the discharge switch in each of the plurality of discharge units to be closed to discharge the peripheral circuit of the target chip.

In a possible implementation, the controlling the at least some pins to be connected to the power supply module according to the sequence of connection includes: controlling the at least some pins to be connected to the power supply module a plurality of times according to a preset number of times based on the sequence of connection.

In a possible implementation, the preset number is greater than or equal to 30.

In a possible implementation, the testing method further includes: after controlling the at least some pins to be connected to the power supply module a plurality of times according to a preset number of times based on the sequence of connection, verifying the function of the target chip.

In a possible implementation, the testing method further includes: in the process of controlling the at least some pins to be connected to the power supply module according to the sequence of connection, confirming whether the circuit function of the target chip is normal according to the reported information from the target chip.

In a possible implementation, the target chip is an analog front end AFE chip.

In a third aspect, a chip is provided, including: a processor configured to invoke a computer program from a memory and run the computer program, causing a device equipped with the chip to execute the method according to the second aspect or in any possible implementation according to the second aspect.

In a fourth aspect, a computer program is provided; and the computer program causes the computer to execute the method according to the second aspect or in any possible implementation according to the second aspect.

In a fifth aspect, a computer-readable storage medium is provided for storing a computer program, and the computer program causes the computer to execute the method according to the second aspect or in any possible implementation according to the second aspect.

In a sixth aspect, a computer program product is provided, including computer program instructions, and the computer program instructions cause the computer to execute the method according to the second aspect or in any possible implementation according to the second aspect.

### BRIEF DESCRIPTION OF DRAWINGS

In order to illustrate the technical solutions of the embodiments of the present application more clearly, the drawings required in the embodiments of the present application are briefly introduced below. Obviously, the drawings described below are only some embodiments of the present application. For those of ordinary skill in the art, other drawings can also be obtained according to these drawings without any creative effort.
FIG. 1 shows a schematic block diagram of a chip testing method according to an embodiment of the present application;
FIG. 2 shows a schematic diagram illustrating the connection relationship between a target chip and a power supply module according to an embodiment of the present application;
FIG. 3 shows a schematic connection diagram of a chip testing system according to an embodiment of the present application;
FIG. 4 shows another schematic connection diagram of a chip testing system according to an embodiment of the present application;
FIG. 5 shows yet another schematic connection diagram of a chip testing system according to an embodiment of the present application;
FIG. 6 shows still another schematic connection diagram of a chip testing system according to an embodiment of the present application;
FIG. 7 shows a schematic block diagram of a chip testing device according to an embodiment of the present application; and
FIG. 8 shows another schematic block diagram of a chip testing device according to an embodiment of the present application.

### DETAILED DESCRIPTION

Embodiments of the present application are described in further detail below in conjunction with the drawings and embodiments. The following detailed description of the embodiments and the drawings are used to illustrate the principles of the present application by way of example, but should not be used to limit the scope of the present application, that is, the present application is not limited to the described embodiments.

In the description of the present application, it is to be noted that unless otherwise stated, "a plurality of" means more than two; in addition, the terms such as "first", "second" and "third" are only intended for the purpose of description, and shall not be construed as indicating or implying relative importance.

As chips become more and more complex, more and more modules are included inside the chip, the manufacturing process is becoming increasingly advanced, and accordingly there are increasingly more failure modes. It has become an increasingly more important consideration in the design process as to how to completely and effectively test the entire chip. Current chip testing solutions still rely mainly on manual testing. Taking the hot-swap test of a chip as an example, it is necessary to manually control the connection and disconnection between the chip pins and the power supply module, as well as to simulate various working conditions of the chip, which greatly wastes time and manpower, resulting in extremely low test efficiency.

In view of this, embodiments of the present application provide a chip testing method in which the pin connection control information of the target chip is acquired to control the sequence of connection between at least some pins of the target chip and the power supply module, thereby realizing intelligent testing of the chip and improving the testing efficiency of the chip.

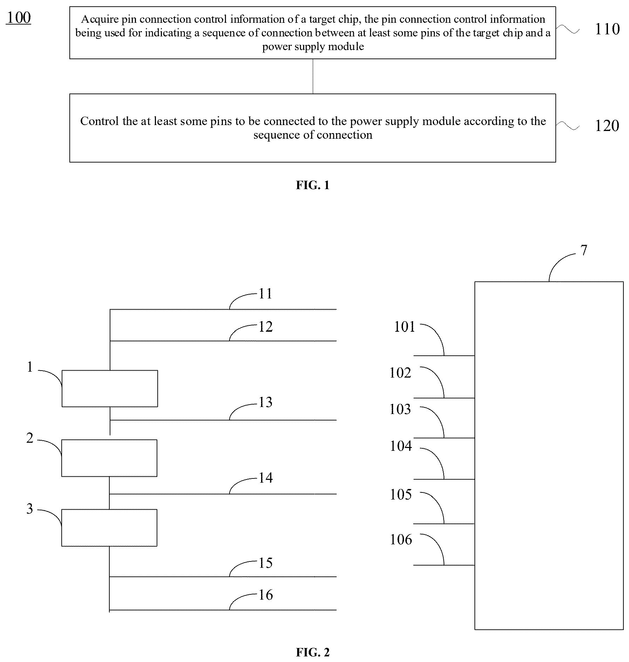

FIG. 1 shows a schematic block diagram of a chip testing method 100 according to an embodiment of the present application. Optionally, the method 100 may be executed by a testing device which, for example, may include an upper computer. As shown in FIG. 1, the method 100 includes some or all of the following steps.

In Step 110, pin connection control information of the target chip is acquired. The pin connection control information is used for indicating a sequence of connection between at least some pins of the target chip and a power supply module.

In Step 120, the at least some pins of the target chip are controlled to be connected to the power supply module according to the sequence of connection.

Optionally, the method 100 may be a hot-swap chip testing method. The so-called hot swap, that is, hot plugging, refers to inserting or removing the chip from the system without turning off the system power. Since hot swap of chips has a significant impact on the system, it is chips usually need to undergo the hot-swap test before leaving the factory to prevent chips failing to meet hot-swap requirements from being released to the market.

Optionally, the hot-swap testing method of the embodiments of the present application may be applied to the field of battery management system (BMS). For example, the hot-swap testing method of the embodiments of the present application can implement a hot-swap test on an analog front end (AFE) chip in a BMS. The AFE chip is a monitoring chip with multiple sampling channels that can monitor the battery voltage and temperature of batteries connected in series. As the sequence of the pins of the AFE chip is not fixed when it is connected to the battery, there may be a voltage difference between two pins, which may cause damage to the AFE chip. Therefore, hot-swap testing of the AFE chip is necessary. After hot-swap testing and verification, AFE chips that meet the requirements are allowed to be released to the market.

Optionally, in an embodiment of the present application, the testing device can acquire pin connection control information of a target chip (also referred to as a chip to be tested), and the pin connection control information may be used for indicating a sequence of connection between at least some pins of the target chip and a power supply module. As an example, the pin connection control information is used for indicating the sequence of connection between all pins of the target chip and the power supply module. As another example, the pin connection control information is used for indicating the sequence of connection between some pins, including the power pin and ground pin, of the target chip and the power supply module. When the pin connection control information is used for indicating the sequence of connection between some pins of the target chip and the power supply module, the pin connection control information may also be used for indicating that the sequence of connection between the other some pins of the target chip and the power supply module is random. Optionally, the sequence of connection indicated by the pin connection control information may be one of a plurality of sequences of connection preset inside the testing device. For example, the target chip includes pins 1 to 3, and a plurality of sequences of connection can be preset according to various arrangements and combinations of the pins 1 to 3, as shown in Table 1. The pin connection control information may be used for indicating one of the 15 sequences of connection in Table 1. After the testing device acquires the pin connection control information, the testing device can control at least some pins of the target chip to be connected to the power supply module according to the sequence of connection indicated by the pin connection control information. For example, the pin connection control information is used for indicating the sequence of connection 10 in Table 1, and the testing device controls the pins of the target chip to be connected sequentially to the power supply module according to the sequence of pin 1 - pin 2 - pin 3.

**Table 1**

| | |
|---|---|
| Sequence of connection 1 | Pin 1 |
| Sequence of connection 2 | Pin 2 |
| Sequence of connection 3 | Pin 3 |
| Sequence of connection 4 | Pin 1 - Pin 2 |
| Sequence of connection 5 | Pin 2 - Pin 1 |
| Sequence of connection 6 | Pin 1 -Pin 3 |
| Sequence of connection 7 | Pin 3 - Pin 1 |
| Sequence of connection 8 | Pin 2 - Pin 3 |
| Sequence of connection 9 | Pin 3 - Pin 2 |
| Sequence of connection 10 | Pin 1 - Pin 2 - Pin 3 |
| Sequence of connection 11 | Pin 2 - Pin 1 - Pin 3 |
| Sequence of connection 12 | Pin 1 - Pin 3 - Pin 2 |
| Sequence of connection 13 | Pin 2 - Pin 3 - Pin 1 |
| Sequence of connection 14 | Pin 3 - Pin 2 - Pin 1 |
| Sequence of connection 15 | Pin 3 - Pin 1 - Pin 2 |

Optionally, in an embodiment of the present application, the power supply module may be a real battery or a cell simulator. Optionally, the power supply module may include a plurality of power supply units connected in series, where one power supply unit may correspond to one battery cell. There is correspondence between the number of power supply units in the power supply module and the number of pins of the target chip.

In this embodiment, the pin connection control information of the target chip is acquired to control the sequence of connection between at least some pins of the target chip and the power supply module, thereby realizing intelligent testing of the chip and improving the testing efficiency of the chip.

Optionally, in an embodiment of the present application, the power supply module may include a plurality of power supply units. The Step 120 of controlling the at least some pins of the target chip to be connected to the power supply module according to the sequence of connection includes: controlling the at least some pins to be connected respectively to positive and negative electrodes of the at least some of the plurality of power supply units according to the sequence of connection.

As mentioned above, the power supply module may include a plurality of power supply units, and the plurality of power supply units may be connected in series. A lead can be pulled out from the positive and negative electrodes of each power supply unit, and the leads pulled out from the plurality of power supply units may correspond to the pins of the target chip. The testing device controls the at least some pins of the target chip to be connected to the power supply module specifically by controlling the at least some pins of the target chip to be connected to at least some leads pulled out from the plurality of power supply units. For example, as shown in FIG. 2, the power supply module includes three power supply units connected in series, denoted respectively as 1, 2 and 3. Six leads can be pulled out from the power supply module and are denoted respectively as 11, 12, 13, 14, 15 and 16. The leads pulled out from the positive electrode and the negative electrode of the power supply module, that is, lead 11 and lead 16, correspond respectively to the power pin 101 and the ground pin 106 of the target chip 7, and the other leads 12 to 15 of the power supply module correspond respectively to the other pins 102 to 105 of the target chip 7. If the sequence of connection indicated by the pin connection control information is power pin 101 - ground pin 106 - pin 102 - pin 103 - pin 104 - pin 105, the testing device can control the connection between the power pin 101 and the lead 11, the connection between the ground pin 106 and the lead 16, the connection between the pin 102 and the lead 12, the connection between the pin 103 and the lead 13, the connection between the pin 104 and the lead 14, and the connection between the pin 105 and the lead 15 sequentially according to the sequence of connection.

Optionally, in an embodiment of the present application, the at least some power supply units include a first power supply unit and a second power supply unit, and the controlling the at least some pins to be connected respectively to positive and negative electrodes of the at least some of the plurality of power supply units according to the sequence of connection includes: controlling two pins among the at least some pins to be connected respectively to the positive electrode of the first power supply unit and the negative electrode of the second power supply unit according to the sequence of connection, so that the voltage between the two pins is U, where U is a sum of the voltages of the plurality of power supply units.

Specifically, as shown in FIG. 2, the power supply module includes a power supply unit 1, a power supply unit 2 and a power supply unit 3, and the power supply unit 1, the power supply unit 2 and the power supply unit 3 are connected in series, where the lead 11 and the lead 12 are connected to the positive electrode of the power supply unit 1, and the lead 15 and the lead 16 are connected to the negative electrode of the power supply unit 3. The testing device can control the power pin 101 and the ground pin 106 of the target chip 7 to be connected to the positive electrode of the power supply unit 1 and the negative electrode of the power supply unit 3 first, that is, the power pin 101 of the target chip 7 is controlled to be connected to the lead 11 and the ground pin 106 of the target chip 7 is controlled to be connected to the lead 16, so that the voltage between the power pin 101 and the ground pin 106 is the sum of the voltages of the power supply unit 1, the power supply unit 2 and the power supply unit 3, that is, the voltage between the power pin 101 and the ground pin 106 is the sum of the voltages of the plurality of power supply units corresponding to the target chip 7, so that the voltage between the power pin 101 and the ground pin 106 is the maximum voltage among the voltages between any two pins among all the pins of the target chip 7.

Optionally, two pins among the at least some pins may be any two pins in the target chip 7, that is, no matter which two pins in the target chip 7 have a voltage between them that is the maximum voltage among the voltages between any two pins among all the pins in the target chip 7, as long as the testing device controls the two pins of the target chip 7 to be connected to the power supply module according to the sequence of connection, there is no limitation on whether other pins are connected to the power supply module.

In this embodiment, two pins among the at least some pins are controlled to be connected respectively to the positive electrode of the first power supply unit and the negative electrode of the second power supply unit according to the sequence of connection, so that the voltage between the two pins is a sum of the voltages of the plurality of power supply units corresponding to the target chip, thereby allowing the target chip to be tested in the working condition where it is most likely to be damaged, which can avoid the release of abnormal chips.

Optionally, in an embodiment of the present application, the positive electrode of the first power supply unit is the positive electrode of the power supply module, and the negative electrode of the second power supply unit is the negative electrode of the power supply module. For example, as shown in FIG. 2, the power supply module includes a power supply unit 1, a power supply unit 2 and a power supply unit 3, and the power supply unit 1, the power supply unit 2 and the power supply unit 3 are connected in series, the positive electrode of power supply unit 1 is the positive electrode of the power supply module, and the negative electrode of power supply unit 3 is the negative electrode of the power supply module. The testing device can control two pins among at least some pins of the target chip 7 to be connected respectively to the positive electrode of the power supply unit 1 and the negative electrode of the power supply unit 3 according to the sequence of connection, so that the voltage between the two pins is the voltage of the power supply module, that is, the sum of the voltages of the power supply unit 1, the power supply unit 2 and the power supply unit 3.

Optionally, in other embodiments of the present application, the power supply module may include power supply submodules 1 to N. Each power supply submodule includes a plurality of power supply units connected in series, and each power supply submodule corresponds to one target chip, that is, the power supply submodules 1 to N correspond to target chips 1 to N. The testing device can control two pins among at least some pins of any target chip i (i is any value from 1 to N) to be connected respectively to the positive and negative electrodes of the power supply submodule i according to the sequence of connection, so that the voltage between the two pins of the target chip i is the voltage of the power supply submodule i.

Optionally, in an embodiment of the present application, the two pins include a power pin and a ground pin of the target chip. That is, the testing device can control the power pin and ground pin of the target chip to be connected respectively to the positive electrode of the first power supply unit and the negative electrode of the second power supply unit according to the sequence of connection, so that the voltage between the power pin and the ground pin of the target chip is the sum of the voltages of the plurality of power supply units corresponding to the target chip.

Optionally, in an embodiment of the present application, the sequence of connection includes: the two pins are connected to the power supply module first. In other words, the testing device can first control two pins among at least some pins of the target chip to be connected to the positive electrode of the first power supply unit and the negative electrode of the second power supply unit first, so that the voltage between the two pins is the sum of the voltages of the plurality of power supply units corresponding to the target chip.

As an example, at least some pins of the target chip may include only the two pins. After the testing device controls the two pins to be connected to the power supply module, the testing device may control other pins of the target chip not to be connected to the power supply module. As another example, at least some pins of the target chip include other pins than the two pins. After the testing device controls the two pins to be connected to the power supply module first, the testing device controls other pins among the at least some pins to be connected to the power supply module.

It should be understood that the embodiment of the present application does not limit the sequential order of the two pins that are first connected to the power supply module.

In this embodiment, by controlling two pins among at least some pins of the target chip to be connected to the power supply module first so that the voltage between the two pins is a sum of the voltages of the plurality of power supply units corresponding to the target chip, the target chip is enabled to be tested in the working condition where it is most likely to be damaged, which can avoid the release of abnormal chips.

Optionally, the sequence of connection may further include: after the two pins are connected to the power supply module first, the pins among the at least some pins of the target chip except the two pins are connected to the power supply module in a random sequence. That is, when at least some pins of the target chip include other pins than the two pins, after the testing device controls the two pins to be connected to the power supply module first, the testing device can control other pins among the at least some pins to be connected to the power supply module in a random sequence. As an example, as shown in FIG. 2, the at least some pins include pins 101 to 103 and 106. The testing device can control the power pin 101 and the ground pin 106 to be connected to the power supply module first, and then control the pins 102 and 103 to be connected to the power supply module in a random sequence. For example, the random sequence may be to connect the pin 102 to the power supply module first, and then connect the pin 103 to the power supply module. As another example, the random sequence may be to first connect the pin 103 to the power supply module, and then connect the pin 102 to the power supply module. The random sequence in the embodiments of the present application means that the sequence of connection in any two consecutive tests may be different.

Optionally, in another embodiment of the present application, the sequence of connection includes: at least some pins of the target chip are connected to the power supply module in a random sequence. For example, as shown in FIG. 2, the at least some pins include pins 101 to 103 and 106, and the testing device can control the pins 101 to 103 and 106 to be connected to the power supply module in a random sequence. As an example, the random sequence may be the sequence of pin 101 - pin 102 - pin 103 - pin 106. As another example, the random sequence may be the sequence of pin 101 - pin 106 - pin 102 - pin 103. As another example, the random sequence may alternatively be the sequence of pin 106 - pin 102 - pin 101 - pin 103. The random sequence in the embodiments of the present application means that the sequence of connection in any two consecutive tests may be different.

Optionally, in another embodiment of the present application, the pin connection control information is further used for indicating a connection delay between the two pins among the at least some pins that are connected sequentially to the power supply module; and Step 120 of controlling the at least some pins to be connected to the power supply module includes: controlling the at least some pins to be connected to the power supply module according to the sequence of connection and the connection delay.

Optionally, the connection delay may be preset inside the testing device like the sequence of connection. For example, a plurality of connection delays may be preset inside the testing device, and the pin connection control information may indicate at least one connection delay among the plurality of connection delays. For example, six connection delays of 500ms, 600ms, 700ms, 800ms, 900ms and 1s can be preset inside the testing device. Optionally, the pin connection control information may indicate only one connection delay among the six connection delays. That is, the delay between any two pins of the target chip that are consecutively connected to the power supply module is the same. For example, if the pin connection control information indicates that the connection delay is 500ms, then the delay between any two pins of the target chip that are consecutively connected to the power supply module is 500ms, that is, the testing device controls one pin of the target chip to be connected to the power supply module every 500ms. Optionally, the pin connection control information may indicate a plurality of connection delays among the six connection delays. For example, as shown in FIG. 2, the testing device controls the pins 101 to 103 and 106 to be connected to the power supply module according to the sequence of connection of pin 101 - pin 106 - pin 102 - pin 103. The pin connection control information is used for indicating three connection delays of 500ms, 800ms and 1s, and the pin connection control information may also indicate that the connection delay between the pin 102 and the pin 106 is 500ms, the connection delay between the pin 106 and the pin 102 is 800ms, and the connection delay between the pin 102 and the pin 103 is 1s. That is, after controlling the pin 101 to be connected to the power supply module, the testing device controls the pin 106 to be connected to the power supply module after 500ms, then controls the pin 102 to be connected to the power supply module after 800ms, and finally controls the pin 103 to be connected to the power supply module after 1s.

Optionally, in an embodiment of the present application, the connection delay may be a random value. For example, the connection delay may be a random value between 500ms and 1s. The connection delay being a random value means that the connection delay between any two of the target chip that are consecutively connected to the power supply module is randomly taken by the testing device and is not preset.

Optionally, in an embodiment of the present application, the pins of the target chip are connected to the power supply module through a switch matrix, and the pin connection control information is used for indicating a switch closing sequence of the switch matrix.

In this embodiment, since the pins of the target chip are connected to the power supply module through the switch matrix, the switch closing sequence of the switch matrix is acquired, and the switches in the switch matrix are closed sequentially according to the switch closing sequence to control at least some pins of the target chip to be connected to the power supply module, thereby improving the testing flexibility of the target chip.

Optionally, the switch matrix may be a relay or a semiconductor switch or the like.

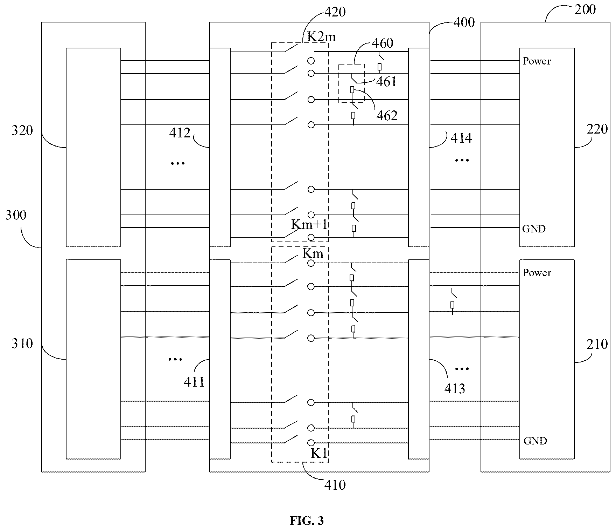

Hereinafter, a chip testing method according to the embodiments of the present application will be described in detail with reference to FIGS. 3 to 6. Specifically, in FIGS. 3 to 6, the target chip is an AFE chip, and two AFE chips form a cell monitor unit (CMU). The test object is a CMU, that is, the method can be used to perform a hot-swap test on the CMU. In addition to the testing device and the test object, the testing system may also include a power supply module. The testing device includes a switch matrix, which may include switches and connectors. The on and off of switches in the switch matrix is equivalent to the connector being connected or unplugged. Optionally, in FIGS. 3 to 6, the control function in the testing device may be implemented by an upper computer. The power supply module may be a real battery or a cell simulator. Optionally, the number ofAFE chips included in a CMU may vary, and the number of battery cells included in the power supply module may also vary during actual application.

Optionally, in a first embodiment, the target chip includes a first target chip and a second target chip, the power supply module includes a first power supply submodule and a second power supply submodule, the switch matrix includes a plurality of first switches, a plurality of second switches, a first connector, a second connector, a third connector and a fourth connector, the first connector is connected to the first power supply submodule, the second connector is connected to the second power supply submodule, the third connector is connected to the first target chip, the fourth connector is connected to the second target chip, the first connector and the third connector are connected through the plurality of first switches, the second connector and the fourth connector are connected through the plurality of second switches, the power pin and the ground pin of the first target chip are connected respectively to the positive electrode and the negative electrode of the first power supply submodule, and the power pin and the ground pin of the second target chip are connected respectively to the positive electrode and the negative electrode of the second power supply submodule.

Optionally, in an implementation, the switch closing sequence may include: two first switches among the plurality of first switches connected to the power pin and the ground pin of the first target chip are closed first, and then the other first switches among the plurality of first switches are randomly closed; and/or two second switches among the second switches connected to the power pin and the ground pin of the second target chip are closed first, and then the other second switches among the plurality of second switches are randomly closed.

Optionally, in another implementation, the plurality of first switches are randomly closed, and/or the plurality of second switches are randomly closed.

For example, as shown in FIG. 3, the target chip includes a first AFE chip 210 and a second AFE chip 220, where the first AFE chip 210 and the second AFE chip 220 form one CMU 200. The power supply module 300 includes a first power supply submodule 310 and a second power supply submodule 320, and the switch matrix 400 includes a first switch group 410 and a second switch group 420. The first switch group 410 includes K1 to Km, and the second switch group 420 includes Km+1 to K2m. The switch matrix 400 further includes a first connector 411 for connecting the first power supply submodule 310, a second connector 412 for connecting the second power supply submodule 320, a third connector 413 for connecting the first AFE chip 210, and a fourth connector 414 for connecting the second AFE chip 220. The first connector 411 and the third connector 413 are connected through the first switch group 410, and the second connector 412 and the fourth connector 414 are connected through the second switch group.

As shown in FIG. 3, the number of battery cells of the first power supply submodule 310 is consistent with the number of sampling channels of the first AFE chip 210, and the sampling leads of the first power supply submodule 310 are all concentrated in the first connector 411, and all sampling channel lines of the first AFE chip 210 are all concentrated in the third connector 413. The number of battery cells of the second power supply submodule 320 is consistent with the number of sampling channels of the second AFE chip 220, and the sampling leads of the second power supply submodule 320 are all concentrated in the second connector 412, and all sampling channel lines of the second AFE chip 220 are all concentrated in the fourth connector 414. Specifically, the positive electrode of the first power supply submodule 310 is connected to the power pin (Power) of the first AFE chip 210 through Km, the negative electrode of the first power supply submodule 320 is connected to the ground pin (GND) of the first AFE chip 210 through K1, the positive electrode of the second power supply submodule 320 is connected to the power pin (Power) of the second AFE chip 220 through K2m, and the negative electrode of the second power supply submodule 320 is connected to the ground pin (GND) of the second AFE chip 220 through Km+1.

Working condition 1 (the worst working condition of the first AFE chip 210 and/or the second AFE chip 220): K1 and Km are closed first (K1 may be closed first and then Km; or Km may be closed first and then K1), and then other switches K2 to Km-1 in the first switch group 410 are randomly closed; and/or Km+1 and K2m are closed first (Km+1 may be closed first and then K2m; or K2m may be closed first and then Km+1), and then other switches Km+2 to K2m-1 in the second switch group 420 are randomly closed. Specifically, the random closure includes random closing sequence and random time delay.

Working condition 2 (the situation of the first AFE chip 210 and/or the second AFE chip 220 closest to the reality): K1 to Km are randomly closed; and/or Km+1 to K2m are randomly closed. Specifically, the random closure includes random closing sequence and random time delay.

Optionally, in a second embodiment, the target chip includes a first target chip or a second target chip, the power supply module includes a first power supply submodule and a second power supply submodule connected in series, the switch matrix includes a plurality of third switches, a first connector, a second connector and a third connector, the first connector is connected to the first power supply submodule, the second connector is connected to the second power supply submodule, the third connector is connected to the first target chip or the second target chip, and the first connector and the second connector are connected to the third connector through the plurality of third switches.

Optionally, the switch closing sequence includes: the some third switches among the plurality of third switches connected to the first connector are closed first, and then the other some third switches among the plurality of third switches connected to the second connector are closed; or the some third switches among the plurality of third switches connected to the second connector are closed first, and then the other some third switches among the plurality of third switches connected to the first connector are closed.

Further optionally, the power pin and the ground pin of the first target chip or the second target chip are connected respectively to the positive electrode and the negative electrode of the power supply module; the some third switches include a third switch connected to the power pin of the first target chip or the second target chip, and the other some third switches include a third switch connected to the ground pin of the first target chip or the second target chip, and the switch closing sequence includes: after the some third switches are closed, the third switch among the other some third switches connected to the ground pin of the first target chip or the second target chip is closed first, and then the other third switches among the other some third switches are randomly closed; or the some third switches include a third switch connected to the ground pin of the first target chip or the second target chip, and the other some third switches include a third switch connected to the power pin of the first target chip or the second target chip, and the switch closing sequence includes: after the some third switches are closed, the third switch among the other some third switches connected to the power pin of the first target chip or the second target chip is closed first, and then the other third switches among the other some third switches are randomly closed.

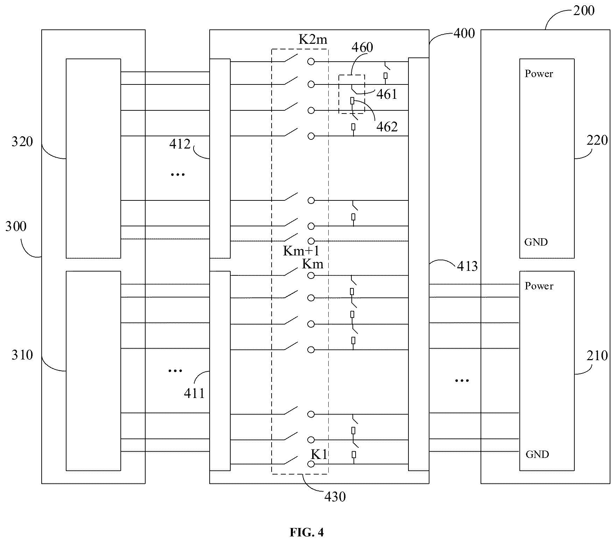

For example, as shown in FIG. 4, the target chip includes a first AFE chip 210 and a second AFE chip 220, where the first AFE chip 210 and the second AFE chip 220 form one CMU 200. The power supply module 300 includes a first power supply submodule 310 and a second power supply submodule 320. The switch matrix 400 includes a third switch group 430. The third switch group 430 includes K1 to K2m. The switch matrix 400 further includes a first connector 411 for connecting the first power supply submodule 310, a second connector 412 for connecting the second power supply submodule 320, and a third connector 413 for connecting the first AFE chip 210 or the second AFE chip 220. Specifically, the power pin of the first AFE chip 210 is connected to the positive electrode of the power supply module 300 through K2m, and the ground pin of the first AFE chip 210 is connected to the negative electrode of the power supply module 300 through K1. Alternatively, the power pin of the second AFE chip 220 is connected to the positive electrode of the power supply module 300 through K2m, and the ground pin of the second AFE chip 220 is connected to the negative electrode of the power supply module 300 through K1.

As shown in FIG. 4, the sum of the number of battery cells of the first power supply submodule 310 and the second power supply submodule 320 is consistent with the number of sampling channels of the first AFE chip 210 or the second AFE chip, and the sampling leads of the first power supply submodule 310 are all concentrated in the first connector 411, the sampling leads of the second power supply submodule 320 are all concentrated in the second connector 412, and all sampling channel lines of the first AFE chip 210 or the second AFE chip 220 are all concentrated in the third connector 413.

Working condition 3: K1 to Km are closed first, and then Km+1 to K2m are closed after a particular delay. During the closing process of Km+1 to K2m, K2m is preferentially closed, and then Km+1 to K2m-1 are closed randomly. The random closing includes the random closing sequence and the random time delay.

Working condition 4: Km+1 to K2m are closed first, and then K1 to Km are closed after a particular delay. During the closing process of K1 to Km, K1 is preferentially closed, and then K2 to Km are closed randomly. The random closing includes the random closing sequence and the random time delay.

Optionally, in a third embodiment, the target chip includes a first target chip and a second target chip, the switch matrix includes a plurality of fourth switches, a plurality of fifth switches, a first connector and a second connector, the first connector is connected to the power supply module, the first target chip and the second target chip are both connected to the second connector, the first connector and the second connector are connected through the plurality of fourth switches and the plurality of fifth switches, the power pin and the ground pin of the first target chip are connected respectively to the positive electrode and the negative electrode of some power supply units in the power supply module, and the power pin and the ground pin of the second target chip are connected respectively to the positive electrode and the negative electrode of the other some power supply units in the power supply module.

Optionally, in an implementation, the switch closing sequence includes: the fourth switch among the plurality of fourth switches connected to the power pin of the first target chip and the fifth switch among the plurality of fifth switches connected to the ground pin of the second target chip are closed first, then the fourth switch among the plurality of fourth switches connected to the ground pin of the first target chip and the fifth switch among the plurality of fifth switches connected to the power pin of the second target chip are closed, and finally the other fourth switches among the plurality of fourth switches and the other fifth switches among the plurality of fifth switches are randomly closed.

Optionally, in another implementation, the switch closing sequence includes: the plurality of fourth switches and the plurality of fifth switches are randomly closed.

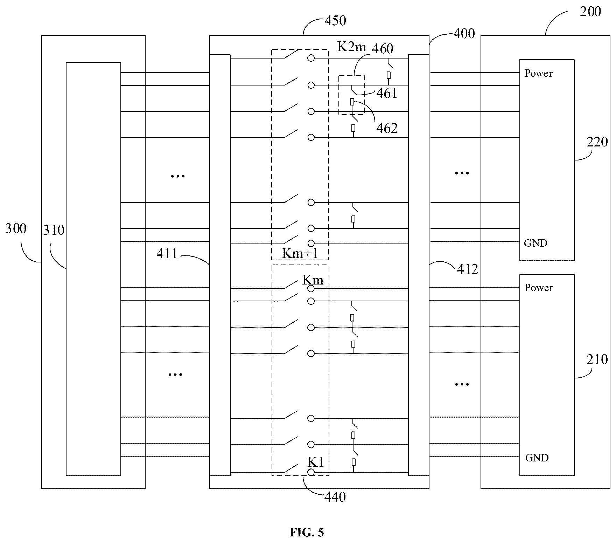

For example, as shown in FIG. 5, the target chip includes a first AFE chip 210 and a second AFE chip 220, where the first AFE chip 210 and the second AFE chip 220 form one CMU 200. The power supply module 300 includes a first power supply submodule 310, and the switch matrix 400 includes a fourth switch group 440 and a fifth switch group 450. The fourth switch group 440 includes K1 to Km, and the fifth switch group 450 includes Km+1 to K2m. The switch matrix 400 further includes a first connector 411 for connecting the first power supply submodule 310, and a second connector 412 for connecting the first AFE chip 210 and the second AFE chip 220. Specifically, the power pin of the first AFE chip 210 is connected to the positive electrodes of the first some battery cells connected in series of the first power supply submodule 310 through Km, the ground pin of the first AFE chip 210 is connected to the negative electrodes of the first some battery cells connected in series of the first power supply submodule 310 through K1, the power pin of the second AFE chip 210 is connected to the positive electrodes of the second some battery cells connected in series of the first power supply submodule 310 through K2m, and the ground pin of the second AFE chip 220 is connected to the negative electrodes of the second some battery cells connected in series of the first power supply submodule 310 through Km+1. Specifically, the positive electrodes of the first some battery cells connected in series are connected to the negative electrodes of the second some battery cells connected in series.

As shown in FIG. 5, the number of the battery cells among the first some battery cells connected in series is consistent with the number of sampling channels of the first AFE chip 210, and the sampling leads of the first power supply submodule 310 are all concentrated in the first connector 411, and all sampling channel lines of the first AFE chip 210 and the second AFE chip 220 are all concentrated in the second connector 412.

Working condition 5: Km and Km+1 are preferentially closed, K1 and K2m are closed after a delay, and the remaining switches are closed randomly. Specifically, the random closure includes random closing sequence and random time delay.

Working condition 6: All the switches K1 to K2m are closed randomly. Specifically, the random closure includes random closing sequence and random time delay.

Optionally, in a fourth embodiment, the target chip includes a first target chip and a second target chip, the switch matrix includes a plurality of fourth switches, a plurality of fifth switches, a first connector and a second connector, the first connector is connected to the power supply module, the first target chip and the second target chip are both connected to the second connector, the first connector and the second connector are connected through the plurality of fourth switches and the plurality of fifth switches, the power pin and the ground pin of the first target chip are connected respectively to the positive electrode and the negative electrode of some power supply units in the power supply module, the power pin and the ground pin of the second target chip are connected respectively to the positive electrode and the negative electrode of the other some power supply units in the power supply module, and the power pin of the first target chip is connected to the ground pin of the second target chip.

In this embodiment, optionally, the switch closing sequence includes: the plurality of fourth switches are closed first, then the fifth switch among the plurality of fifth switches connected to the power pin of the second target chip is closed, and finally the other fifth switches among the plurality of fifth switches are randomly closed, or the plurality of fifth switches are closed first, then the fourth switch among the plurality of fourth switches connected to the ground pin of the first target chip is closed, and finally the other fourth switches among the plurality of fourth switches are randomly closed.

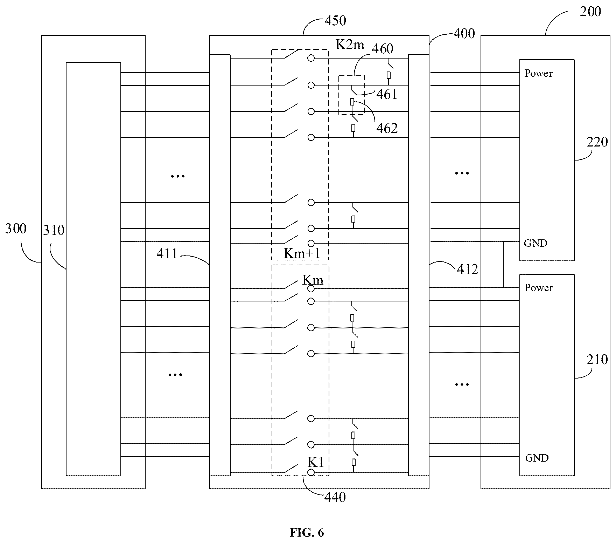

For example, as shown in FIG. 6, the target chip includes a first AFE chip 210 and a second AFE chip 220, where the first AFE chip 210 and the second AFE chip 220 form one CMU 200. The power supply module 300 includes a first power supply submodule 310, and the switch matrix 400 includes a fourth switch group 440 and a fifth switch group 450. The fourth switch group 440 includes K1 to Km, and the fifth switch group 450 includes Km+1 to K2m. The switch matrix 400 further includes a first connector 411 for connecting the first power supply submodule 310, and a second connector 412 for connecting the first AFE chip 210 and the second AFE chip 220. Specifically, the power pin of the first AFE chip 210 is connected to the positive electrodes of the first some battery cells connected in series of the first power supply submodule 310 through Km, the ground pin of the first AFE chip 210 is connected to the negative electrodes of the first some battery cells connected in series of the first power supply submodule 310 through K1, the power pin of the second AFE chip 210 is connected to the positive electrodes of the second some battery cells connected in series of the first power supply submodule 310 through K2m, and the ground pin of the second AFE chip 220 is connected to the negative electrodes of the second some battery cells connected in series of the first power supply submodule 310 through Km+1. Specifically, the positive electrodes of the first some battery cells connected in series are connected to the negative electrodes of the second some battery cells connected in series. The power pin of the first AFE chip 210 is connected to the ground pin of the second AFE chip 220.

As shown in FIG. 6, the number of the battery cells among the first some battery cells connected in series is consistent with the number of sampling channels of the first AFE chip 210, and the sampling leads of the first power supply submodule 310 are all concentrated in the first connector 411, and all sampling channel lines of the first AFE chip 210 and the second AFE chip 220 are all concentrated in the second connector 412.

Working condition 7: Km+1 to K2m are preferentially closed, then K1 is closed after a delay, and finally K2 to Km are closed randomly.

Working condition 8: K1 to Km are preferentially closed, then K2m is closed after a delay, and finally Km+1 to K2m-1 are closed randomly.

Optionally, in embodiments of the present application, the switch matrix includes a plurality of discharge units, each of the plurality of discharge units is respectively arranged between two pins in the target chip, and the processor is further configured to: before acquiring the pin connection control information of the target chip, control the plurality of discharge units to discharge a peripheral circuit of the target chip.

In an embodiment, one discharge unit is arranged between every two adjacent pins of the target chip.

In another embodiment, one discharge unit is arranged between each of all the pins of the target chip except the ground pin and the ground pin.

Further optionally, the discharge unit includes a discharge switch and a resistor connected in series with the discharge switch, and the controlling the plurality of discharge units to discharge a peripheral circuit of the target chip includes: controlling the discharge switch in each of the plurality of discharge units to be closed to discharge the peripheral circuit of the target chip.

For example, as shown in FIGS. 3 to 6, the switch matrix 400 further includes a plurality of discharge units 460, which are respectively arranged between every two pins of the AFE chip. Each discharge unit 460 includes a discharge switch 461 and a discharge resistor 462. The discharge switch 461 and the discharge resistor 462 are connected in series. After power-off in each hot-swap simulation, the discharge switches 461 in all the discharge units 460 are closed to discharge the peripheral circuits of the first AFE chip 210 and/or the second AFE chip 220, so that the first AFE chip 210 and/or the second AFE chip 220 are restored to an initial state.

In this embodiment, a plurality of discharge units are arranged in the switch matrix to discharge the peripheral circuit of the target chip after each hot-swap test is completed, to ensure that each hot-swap test is in the same initial state, thereby avoiding the problem that the target chip is partially charged after the first hot-swap test, resulting in increasingly weaker subsequent hot-swap stress, which causes the test to be in vain. Besides, adding discharge units can also make each test of the target chip closer to the actual situation, thereby improving the accuracy of the test.

Optionally, in other embodiments, a discharge unit may be arranged between each pin and the ground pin in the AFE chip in FIGS. 3 to 6.

Optionally, in the embodiments of the present application, as mentioned above, the target chip is an AFE chip.

In this embodiment, a hot-swap test of the AFE chip is performed at the AFE chip design end, which can avoid the release of abnormal AFE chips, thereby reducing terminal application losses, speeding up the design and application of the terminal, and promoting the healthy development of the new energy industry.

Optionally, in the embodiments of the present application, Step 220 of controlling the at least some pins to be connected to the power supply module according to the sequence of connection includes: controlling the at least some pins to be connected to the power supply module a plurality of times according to a preset number of times based on the sequence of connection.

Specifically, the process in which the testing device connects the pins of the target chip to the power supply module according to the sequence of connection and then controls all the pins of the target chip to be disconnected from the power supply module can be regarded as one test of the target chip. The testing device can perform a plurality of tests on the target chip according to the same sequence of connection or different sequences of connection. For example, the preset number of tests is greater than or equal to 30.

Taking FIG. 3 as an example, in working condition 1, the switch matrix can be controlled 30 times in the sequence of first closing K1 and Km and then other switches are randomly closed. Optionally, within these 30 times, each closing sequence is to close K1 and Km first, but the closing sequence of other switches may be the same or different. Optionally, each time the closing sequence is changed, the switch matrix may be controlled 30 times according to the same closing sequence until all closing sequences are acquired.

In this embodiment, the test is repeated a plurality of times in the same working condition to improve the credibility of the test.

Optionally, in the embodiments of the present application, the method further includes: after controlling the at least some pins to be connected to the power supply module a plurality of times according to a preset number of times based on the sequence of connection, verifying the function of the target chip.

For example, after the CMU is tested using the testing system in FIGS. 3 to 6, the power supply voltage range of the CMU may be verified. The verification of the power supply voltage range may include the steps of: placing the CMU in a temperature box, and then adjusting the temperature in the temperature box to a specified temperature value; powering on the CMU, adjusting the voltage of a cell core to a specified value, and checking whether the CMU function meets the specified requirements; when the temperature of the CMU is stabilized, maintaining the temperature for a specified operating time in this condition; and during operation, monitoring the working status of the CMU in real time to determine whether it meets the specified requirements. Specifically, the number of CMU chips is 6, the operating time is 24h, and the combinations of ambient temperature and power supply voltage are shown in Table 2.

**Table 2**

| Ambient temperature | Power supply voltage |
|---|---|
| -40°C | 1.50V*N_min |
| + 125°C | 1.50V*N_min |
| -40°C | 5.00V*N |
| +125°C | 5.00V*N |
| +25°C | 3.65V*N |

In the table, N is the number of configurable sampling channels of the AFE chip, and N_min is the minimum number of configurable sampling channels of the AFE chip.

In this embodiment, after testing the target chip, the function of the target chip is further verified to ensure that the chip is released to the market for application only when the functional status level meets particular requirements, thereby reducing the loss on the application side.

Optionally, in the embodiments of the present application, the method further includes: in the process of controlling the at least some pins to be connected to the power supply module according to the sequence of connection, confirming whether the circuit function of the target chip is normal according to the reported information from the target chip.

That is to say, the testing device may have two functions, one is to control the pins of the target chip to be connected to the power supply module according to the acquired pin connection control information, and the other is to receive the reported information from the target chip so that the testing device can confirm whether the circuit function of the target chip is normal based on the reported information. For example, the upper computer reads the information of the CMU to confirm whether the circuit function of the CMU is normal after hot swapping.

The hot-swap test solution of the CMU including the AFE chip according to the embodiments of the present application will be described in detail below. Specifically, the CMU performs a hot-swap test according to the following testing method. Test requirements: The number of CMUs is 6; the number of sampling channels of the AFE chip (i.e., configured series count) is N; (a) the CMU status is that after the verification of the power supply voltage range, all functions and parameters of the DUT meet the design specification requirements; the battery cell voltage value is 4.25V, which can be determined through negotiation between the manufacturer and the user, and the differences shall be stated in the test report; the number of hot swaps is not less than 30; the hot swap working condition may be any of the above working conditions 1 to 8 depending on the connection relationship between the power supply module and the CMU. The test includes the following steps: (a) Setting up the CMU according to the requirements of the hot-swap test bench; (b) Powering on the CMU, adjusting the voltage of the cell core to the specified value, and checking whether the CMU function meets the specified requirements; (c) Powering off the CMU and discharging the residual charge; (d) Simulating the hot-swap scenario and corresponding working conditions, sequentially connecting the corresponding battery channels, and after all channels have been connected, checking whether the CMU function is normal; (e) Repeating processes c to d to complete the number of hot-swap tests required in this working condition; and (f) Repeating processes c to e to meet the test requirements of the remaining hot-swap working conditions.

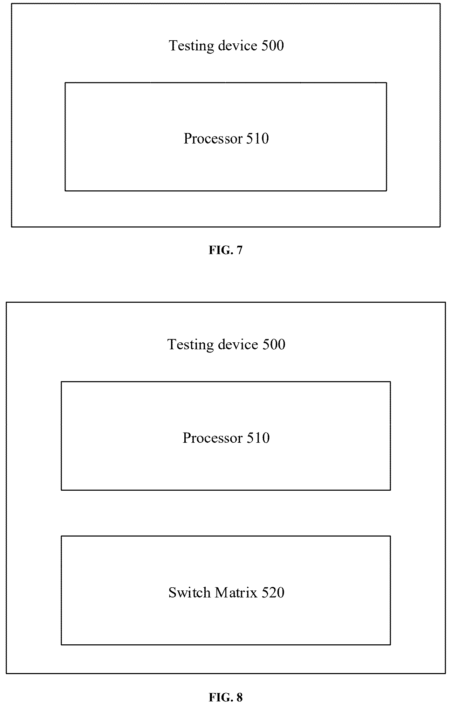

The chip testing method in the embodiments of the present application has been described in detail above, and a chip testing device in the embodiments of the present application will be described in detail below in conjunction with FIGS. 7 to 8, and the technical features described in the method embodiment are applicable to the following apparatus embodiment.

FIG. 7 shows a schematic block diagram of a chip testing device 500 according to an embodiment of the present application. As shown in Fig. 7, the testing device 500 includes some or all of the following components.

It includes a processor 510 configured to acquire pin connection control information of a target chip, the pin connection control information being used for indicating a sequence of connection between at least some pins of the target chip and a power supply module. The processor 510 is further configured to control the at least some pins to be connected to the power supply module according to the sequence of connection.

Optionally, in an embodiment of the present application, the power supply module includes a plurality of power supply units, and the processor 510 is specifically configured to: control the at least some pins to be connected respectively to positive and negative electrodes of at least some of the plurality of power supply units according to the sequence of connection.

Optionally, in an embodiment of the present application, the at least some power supply units include a first power supply unit and a second power supply unit, and the processor 510 is specifically configured to: control two pins among the at least some pins to be connected respectively to the positive electrode of the first power supply unit and the negative electrode of the second power supply unit according to the sequence of connection, so that the voltage between the two pins is U, where U is a sum of the voltages of the plurality of power supply units.

Optionally, in an embodiment of the present application, the positive electrode of the first power supply unit is the positive electrode of the power supply module, and the negative electrode of the second power supply unit is the negative electrode of the power supply module.

Optionally, in an embodiment of the present application, the two pins include a power pin and a ground pin of the target chip.

Optionally, in an embodiment of the present application, the sequence of connection includes: the two pins are connected respectively to the power supply module first.

Optionally, in an embodiment of the present application, the sequence of connection further includes: after the two pins are connected to the power supply module, the pins among the at least some pins except the two pins are connected to the power supply module in a random sequence.

Optionally, in an embodiment of the present application, the sequence of connection includes: at least some pins are connected to the power supply module in a random sequence.

Optionally, in an embodiment of the present application, the pin connection control information is further used for indicating a connection delay between the two pins among the at least some pins that are connected sequentially to the power supply module; and the processor 510 is specifically configured to control the at least some pins to be connected to the power supply module according to the sequence of connection and the connection delay.

Optionally, in an embodiment of the present application, the connection delay is a random value.

Optionally, as shown in FIG. 8, the testing device 500 further includes a switch matrix 520, through which the pins of the target chip are connected to the power supply module, and the pin connection control information is used for indicating a switch closing sequence of the switch matrix 520.

Optionally, in an embodiment of the present application, the power supply module includes a first power supply submodule and a second power supply submodule, the target chip includes a first target chip and a second target chip, the switch matrix 520 includes a plurality of first switches, a plurality of second switches, a first connector, a second connector, a third connector and a fourth connector, the first connector is connected to the first power supply submodule, the second connector is connected to the second power supply submodule, the third connector is connected to the first target chip, the fourth connector is connected to the second target chip, the first connector and the third connector are connected through the plurality of first switches, the second connector and the fourth connector are connected through the plurality of second switches, the power pin and the ground pin of the first target chip are connected respectively to the positive electrode and the negative electrode of the first power supply submodule, and the power pin and the ground pin of the second target chip are connected respectively to the positive electrode and the negative electrode of the second power supply submodule.

Optionally, in an embodiment of the present application, the switch closing sequence includes: two first switches among the plurality of first switches connected to the power pin and the ground pin of the first target chip are closed first, and then the other first switches among the plurality of first switches are randomly closed; and/or two second switches among the second switches connected to the power pin and the ground pin of the second target chip are closed first, and then the other second switches among the plurality of second switches are randomly closed.

Optionally, in an embodiment of the present application, the switch closing sequence includes: the plurality of first switches are randomly closed, and/or the plurality of second switches are randomly closed.

Optionally, in an embodiment of the present application, the power supply module includes a first power supply submodule and a second power supply submodule connected in series, the target chip includes a first target chip or a second target chip, the switch matrix 520 includes a plurality of third switches, a first connector, a second connector and a third connector, the first connector is connected to the first power supply submodule, the second connector is connected to the second power supply submodule, the third connector is connected to the first target chip or the second target chip, and the first connector and the second connector are connected to the third connector through the plurality of third switches.

Optionally, in an embodiment of the present application, the switch closing sequence includes: the some third switches among the plurality of third switches connected to the first power supply submodule are closed first, and then the other some third switches among the plurality of third switches connected to the second power supply submodule are closed; or the some third switches among the plurality of third switches connected to the second power supply submodule are closed first, and then the other some third switches among the plurality of third switches connected to the first power supply submodule are closed.

Optionally, in an embodiment of the present application, the power pin and the ground pin of the first target chip or the second target chip are connected respectively to the positive electrode and the negative electrode of the power supply module; the some third switches include a third switch connected to the power pin of the first target chip or the second target chip, and the other some third switches include a third switch connected to the ground pin of the first target chip or the second target chip, and the switch closing sequence includes: after the some third switches are closed, the third switch among the other some third switches connected to the ground pin of the first target chip or the second target chip is closed first, and then other third switches among the other some third switches are randomly closed; or the some third switches include a third switch connected to the ground pin of the first target chip or the second target chip, and the other some third switches include a third switch connected to the power pin of the first target chip or the second target chip, and the switch closing sequence includes: after the some third switches are closed, the third switch among the other some third switches connected to the power pin of the first target chip or the second target chip is closed first, and then other third switches among the other some third switches are randomly closed.

Optionally, in an embodiment of the present application, the target chip includes a first target chip and a second target chip, the switch matrix 520 includes a plurality of fourth switches, a plurality of fifth switches, a first connector and a second connector, the first connector is connected to the power supply module, the first target chip and the second target chip are both connected to the second connector, the first connector and the second connector are connected through the plurality of fourth switches and the plurality of fifth switches, the power pin and the ground pin of the first target chip are connected respectively to the positive electrode and the negative electrode of some power supply units in the power supply module, and the power pin and the ground pin of the second target chip are connected respectively to the positive electrode and the negative electrode of other some power supply units in the power supply module.

Optionally, in an embodiment of the present application, the switch closing sequence includes: the fourth switch among the plurality of fourth switches connected to the power pin of the first target chip and the fifth switch among the plurality of fifth switches connected to the ground pin of the second target chip are closed first, then the fourth switch among the plurality of fourth switches connected to the ground pin of the first target chip and the fifth switch among the plurality of fifth switches connected to the power pin of the second target chip are closed, and finally the other fourth switches among the plurality of fourth switches and the other fifth switches among the plurality of fifth switches are randomly closed.

Optionally, in an embodiment of the present application, the switch closing sequence includes: the plurality of fourth switches and the plurality of fifth switches are randomly closed.

Optionally, in an embodiment of the present application, the power pin of the first target chip is connected to the ground pin of the second target chip.

Optionally, in an embodiment of the present application, the switch closing sequence includes: the plurality of fourth switches are closed first, then the fifth switch among the plurality of fifth switches connected to the power pin of the second target chip is closed, and finally the other fifth switches among the plurality of fifth switches are randomly closed, or the plurality of fifth switches are closed first, then the fourth switch among the plurality of fourth switches connected to the ground pin of the first target chip is closed, and finally the other fourth switches among the plurality of fourth switches are randomly closed.

Optionally, in an embodiment of the present application, the switch matrix 520 includes a plurality of discharge units, each of the plurality of discharge units is respectively arranged between two pins in the target chip, and before acquiring the pin connection control information of the target chip, the processor 510 is further configured to: control the plurality of discharge units to discharge a peripheral circuit of the target chip.

Optionally, in an embodiment of the present application, one discharge unit is arranged between every two adjacent pins of the target chip.

Optionally, in an embodiment of the present application, one discharge unit is arranged between each of all the pins of the target chip except the ground pin and the ground pin.

Optionally, in an embodiment of the present application, the discharge unit includes a discharge switch and a resistor connected in series with the discharge switch, and the processor 510 is specifically configured to: control the discharge switch in each of the plurality of discharge units to be closed to discharge the peripheral circuit of the target chip.

Optionally, in an embodiment of the present application, the processor 510 is specifically configured to: control the at least some pins to be connected to the power supply module a plurality of times according to a preset number of times based on the sequence of connection.

Optionally, in an embodiment of the present application, the preset number is greater than or equal to 30.

Optionally, in an embodiment of the present application, the processor 510 is further configured to: after controlling the at least some pins to be connected to the power supply module a plurality of times according to a preset number of times based on the sequence of connection, verify the function of the target chip.

Optionally, in an embodiment of the present application, the processor 510 is further configured to: in the process of controlling the at least some pins to be connected to the power supply module according to the sequence of connection, confirm whether the circuit function of the target chip is normal according to the reported information from the target chip.

Optionally, in an embodiment of the present application, the target chip is an analog front-end AFE chip.

Optionally, the testing device further includes a memory, where the memory is configured to store instructions, and the processor 510 is configured to read the instructions and perform the methods of the various embodiments of the present application described above based on the instructions.

The memory may be a separate device independent of the processor 510 or integrated into the processor 510.

Optionally, the testing device may further include a transceiver, and the processor 510 can control the transceiver to communicate with other devices. Specifically, information or data may be transmitted to or received from other devices.

It should be understood that various modules or units in the testing device 500 can implement the corresponding process in the chip testing method provided in the embodiments of the present application. For the sake of brevity, description thereof will be omitted herein.

An embodiment of the present application further provides a chip, including a processor configured to invoke a computer program from a memory and run the computer program to cause the device equipped with this chip to implement the methods in the various embodiments of the present application described above.

It should be understood that the processor in the embodiments of the present application may be an integrated circuit chip with signal processing capability. In the implementation process, various steps of the above method embodiment can be completed by integrated logic circuits in hardware or instructions in the form of software in the processor. The processor may be a general-purpose processor, a Digital Signal Processor (DSP), an Application Specific Integrated Circuit (ASIC), a Field Programmable Gate Array (FPGA) or another programmable logic device, a discrete gate or transistor logic device, or a discrete hardware component. The methods, steps, and logical block diagrams as disclosed in the embodiments of the present application can be implemented or performed. The general-purpose processor may be a microprocessor, or the processor may also be any conventional processor, etc. The steps of the method disclosed in conjunction with the embodiments of the present application can be directly embodied as being performed by the hardware decoding processor or being performed with a combination of hardware and software modules in the decoding processor. The software module may be located in a random access memory, a flash memory, a read-only memory, a programmable read-only memory, or an electrically erasable programmable memory, a register, or the like mature storage media in the art. The storage medium is located in the memory, and the processor reads the information in the memory and completes the steps of the aforementioned method in combination with the hardware thereof.

It can be understood that the memory in the embodiments of the present application may be a volatile memory or a non-volatile memory, or may include both volatile and non-volatile memories. Among them, the non-volatile memory may be a Read-Only Memory (ROM), a Programmable ROM (PROM), an Erasable PROM (EPROM), an Electrically EPROM (EEPROM), or a flash memory. The volatile memory may be a Random Access Memory (RAM), which is used as an external cache. By way of example and not limitation, many forms of RAMs are available, such as Static RAM (SRAM), Dynamic RAM (DRAM), Synchronous DRAM (SDRAM), Double Data Rate SDRAM (DDR SDRAM), Enhanced SDRAM (ESDRAM), Synchlink DRAM (SLDRAM), and Direct Rambus RAM (DR RAM). It is to be noted that the memories in the system and method described herein include, but is not limited to, these and any other appropriate types of memory.

An embodiment of the present application further provides a computer storage medium for storing a computer program, and the computer program is configured to perform the methods of various embodiments of the present application described above.

Optionally, the computer-readable storage medium can be applied to the testing device in the embodiments of the present application, and the computer program causes the computer to perform the corresponding processes implemented by the testing device in the various methods of the embodiments of the present application. For the sake of brevity, description thereof will be omitted herein.

An embodiment of the present application further provides a computer program product which includes computer program instructions.

Optionally, the computer program product can be applied to the testing device in the embodiments of the present application, and the computer program instructions cause the computer to perform the corresponding processes implemented by the testing device in the various methods of the embodiments of the present application. For the sake of brevity, description thereof will be omitted herein.

An embodiment of the present application further provides a computer program.

Optionally, the computer program can be applied to the testing device in the embodiments of the present application. When the computer program runs on a computer, it causes the computer to perform the corresponding processes implemented by the testing device in various methods of the embodiments of the present application. For the sake of brevity, description thereof will be omitted herein.

While the above description merely provides specific embodiments of the present application, the scope of protection of the present application is not limited to the specific embodiments. Any person skilled in the art can easily conceive of alterations or replacements within the technical scope disclosed in the present application. All these alterations or replacements should be encompassed within the scope of protection of the present application. Therefore, the scope of protection of the present application shall be defined by the scope of protection of the claims.

## Claims

1. A chip testing device, comprising: a processor configured to acquire pin connection control information of a target chip, the pin connection control information being used for indicating a sequence of connection between at least some pins of the target chip and a power supply module;
and further configured to control the at least some pins to be connected to the power supply module according to the sequence of connection.

2. The testing device according to claim 1, wherein the power supply module comprises a plurality of power supply units, and the processor is specifically configured to:
control the at least some pins to be connected respectively to positive and negative electrodes of at least some of the plurality of power supply units according to the sequence of connection.

3. The testing device according to claim 2, wherein the at least some power supply units comprise a first power supply unit and a second power supply unit, and the processor is specifically configured to:
control two pins among the at least some pins to be connected respectively to a positive electrode of the first power supply unit and a negative electrode of the second power supply unit according to the sequence of connection, so that the voltage between the two pins is U, wherein U is a sum of the voltages of the plurality of power supply units.

4. The testing device according to claim 3, wherein the positive electrode of the first power supply unit is the positive electrode of the power supply module, and the negative electrode of the second power supply unit is the negative electrode of the power supply module.

5. The testing device according to claim 3 or 4, wherein the two pins comprise a power pin and a ground pin of the target chip.

6. The testing device according to any one of claims 3 to 5, wherein the sequence of connection comprises: the two pins are connected to the power supply module first.

7. The testing device according to claim 6, wherein the sequence of connection further comprises: after the two pins are connected to the power supply module, the pins among the at least some pins except the two pins are connected to the power supply module in a random sequence.

8. The testing device according to claim 1 or 2, wherein the sequence of connection comprises: the at least some pins are connected to the power supply module in a random sequence.

9. The testing device according to any one of claims 1 to 8, wherein the testing device further comprises a switch matrix, through which the pins of the target chip are connected to the power supply module, and the pin connection control information is used for indicating a switch closing sequence of the switch matrix.

10. The testing device according to claim 9, wherein the power supply module comprises a first power supply submodule and a second power supply submodule, the target chip comprises a first target chip and a second target chip, the switch matrix comprises a plurality of first switches, a plurality of second switches, a first connector, a second connector, a third connector and a fourth connector, the first connector is connected to the first power supply submodule, the second connector is connected to the second power supply submodule, the third connector is connected to the first target chip, the fourth connector is connected to the second target chip, the first connector and the third connector are connected through the plurality of first switches, the second connector and the fourth connector are connected through the plurality of second switches, the power pin and the ground pin of the first target chip are connected respectively to a positive electrode and a negative electrode of the first power supply submodule, and the power pin and the ground pin of the second target chip are connected respectively to a positive electrode and a negative electrode of the second power supply submodule.

11. The testing device according to claim 10, wherein the switch closing sequence comprises: two first switches among the plurality of first switches connected to the power pin and the ground pin of the first target chip are closed first, and then the other first switches among the plurality of first switches are randomly closed; and/or
two second switches among the second switches connected to the power pin and the ground pin of the second target chip are closed first, and then the other second switches among the plurality of second switches are randomly closed.

12. The testing device according to claim 10, wherein the switch closing sequence comprises: the plurality of first switches are randomly closed, and/or the plurality of second switches are randomly closed.

13. The testing device according to claim 9, wherein the power supply module comprises a first power supply submodule and a second power supply submodule connected in series, the target chip comprises a first target chip or a second target chip, the switch matrix comprises a plurality of third switches, a first connector, a second connector and a third connector, the first connector is connected to the first power supply submodule, the second connector is connected to the second power supply submodule, the third connector is connected to the first target chip or the second target chip, and the first connector and the second connector are connected to the third connector through the plurality of third switches.

14. The testing device according to claim 13, wherein the switch closing sequence comprises: the some third switches among the plurality of third switches connected to the first connector are closed first, and then the other some third switches among the plurality of third switches connected to the second connector are closed; or
the some third switches among the plurality of third switches connected to the second connector are closed first, and then the other some third switches among the plurality of third switches connected to the first connector are closed.

15. The testing device according to claim 14, wherein the power pin and the ground pin of the first target chip or the second target chip are connected respectively to the positive electrode and the negative electrode of the power supply module;
the some third switches comprise a third switch connected to the power pin of the first target chip or the second target chip, and the other some third switches comprise a third switch connected to the ground pin of the first target chip or the second target chip, and the switch closing sequence comprises: after the some third switches are closed, the third switch among the other some third switches connected to the ground pin of the first target chip or the second target chip is closed first, and then the other third switches among the other some third switches are randomly closed; or
the some third switches comprise a third switch connected to the ground pin of the first target chip or the second target chip, and the other some third switches comprise a third switch connected to the power pin of the first target chip or the second target chip, and the switch closing sequence comprises: after the some third switches are closed, the third switch among the other some third switches connected to the power pin of the first target chip or the second target chip is closed first, and then the other third switches among the other some third switches are randomly closed.

16. The testing device according to claim 9, wherein the target chip comprises a first target chip and a second target chip, the switch matrix comprises a plurality of fourth switches, a plurality of fifth switches, a first connector and a second connector, the first connector is connected to the power supply module, the first target chip and the second target chip are both connected to the second connector, the first connector and the second connector are connected through the plurality of fourth switches and the plurality of fifth switches, the power pin and the ground pin of the first target chip are connected respectively to the positive electrode and the negative electrode of some power supply units in the power supply module, and the power pin and the ground pin of the second target chip are connected respectively to the positive electrode and the negative electrode of the other some power supply units in the power supply module.

17. The testing device according to claim 16, wherein the switch closing sequence comprises: the fourth switch among the plurality of fourth switches connected to the power pin of the first target chip and the fifth switch among the plurality of fifth switches connected to the ground pin of the second target chip are closed first, then the fourth switch among the plurality of fourth switches connected to the ground pin of the first target chip and the fifth switch among the plurality of fifth switches connected to the power pin of the second target chip are closed, and finally the other fourth switches among the plurality of fourth switches and the other fifth switches among the plurality of fifth switches are randomly closed.

18. The testing device according to claim 16, wherein the switch closing sequence comprises: the plurality of fourth switches and the plurality of fifth switches are randomly closed.

19. The testing device according to claim 16, wherein the power pin of the first target chip is connected to the ground pin of the second target chip.

20. The testing device according to claim 19, wherein the switch closing sequence comprises: the plurality of fourth switches are closed first, then the fifth switch among the plurality of fifth switches connected to the power pin of the second target chip is closed, and finally the other fifth switches among the plurality of fifth switches are closed randomly, or
the plurality of fifth switches are closed first, then the fourth switch among the plurality of fourth switches connected to the ground pin of the first target chip is closed, and finally the other fourth switches among the plurality of fourth switches are randomly closed.

21. The testing device according to any one of claims 9 to 20, wherein the switch matrix comprises a plurality of discharge units, each of the plurality of discharge units is respectively arranged between two pins in the target chip, and the processor is further configured to:
before acquiring the pin connection control information of the target chip, control the plurality of discharge units to discharge a peripheral circuit of the target chip.

22. The testing device according to claim 21, wherein one discharge unit is arranged between every two adjacent pins of the target chip.

23. The testing device according to claim 21, wherein one discharge unit is arranged between each of all the pins of the target chip except the ground pin and the ground pin.

24. The testing device according to any one of claims 21 to 23, wherein the discharge unit comprises a discharge switch and a resistor connected in series with the discharge switch, and the processor is specifically configured to:
control the discharge switch in each of the discharge units to be closed to discharge the peripheral circuit of the target chip.

25. The testing device according to any one of claims 1 to 24, wherein the processor is specifically configured to:
control the at least some pins to be connected to the power supply module a plurality of times according to a preset number of times based on the sequence of connection.

26. The testing device according to claim 25, wherein the processor is further configured to:
after controlling the at least some pins to be connected to the power supply module a plurality of times according to a preset number of times based on the sequence of connection, verify the function of the target chip.

27. A chip testing method, comprising:
acquiring pin connection control information of a target chip, the pin connection control information being used for indicating a sequence of connection between at least some pins of the target chip and a power supply module; and
controlling the at least some pins to be connected to the power supply module according to the sequence of connection.

28. The testing method according to claim 27, wherein the power supply module comprises a plurality of power supply units, and the controlling the at least some pins to be connected to the power supply module according to the sequence of connection comprises:
controlling the at least some pins to be connected respectively to positive and negative electrodes of at least some of the plurality of power supply units according to the sequence of connection.

29. The testing method according to claim 28, wherein the at least some power supply units comprise a first power supply unit and a second power supply unit, and the controlling the at least some pins to be connected respectively to positive and negative electrodes of at least some of the plurality of power supply units according to the sequence of connection comprises:
controlling two pins among the at least some pins to be connected respectively to a positive electrode of the first power supply unit and a negative electrode of the second power supply unit according to the sequence of connection, so that the voltage between the two pins is U, wherein U is a sum of the voltages of the plurality of power supply units.

30. The testing method according to claim 29, wherein the sequence of connection comprises: the two pins are connected respectively to the power supply module first.

31. The testing method according to claim 30, wherein the sequence of connection further comprises: after the two pins are connected to the power supply module, the pins among the at least some pins except the two pins are connected to the power supply module in a random sequence.

32. The testing method according to claim 27 or 28, wherein the sequence of connection comprises: the at least some pins are connected to the power supply module in a random sequence.

33. The testing method according to any one of claims 27 to 32, wherein the pin connection control information is further used for indicating a connection delay between the two pins among the at least some pins that are connected sequentially to the power supply module; and
the controlling the at least some pins to be connected to the power supply module according to the sequence of connection comprises:
controlling the at least some pins to be connected to the power supply module according to the sequence of connection and the connection delay.

34. The testing method according to any one of claims 27 to 33, wherein the pins among the target chip are connected to the power supply module through a switch matrix, and the pin connection control information is used for indicating a switch closing sequence of the switch matrix.

35. The testing method according to claim 34, wherein the switch matrix comprises a plurality of discharge units, each of the plurality of discharge units is respectively arranged between two pins in the target chip, and the testing method further comprises:
before acquiring the pin connection control information of the target chip, controlling the plurality of discharge units to discharge a peripheral circuit of the target chip.

36. The testing method according to claim 35, wherein the discharge unit comprises a discharge switch and a resistor connected in series with the discharge switch, and the controlling the plurality of discharge units to discharge a peripheral circuit of the target chip comprises:
controlling the discharge switch in each of the plurality of discharge units to be closed to discharge the peripheral circuit of the target chip.

37. The testing method according to any one of claims 27 to 36, wherein the controlling the at least some pins to be connected to the power supply module according to the sequence of connection comprises:
controlling the at least some pins to be connected to the power supply module a plurality of times according to a preset number of times based on the sequence of connection.

38. The testing method according to claim 37, further comprising:
after controlling the at least some pins to be connected to the power supply module a plurality of times according to a preset number of times based on the sequence of connection, verifying the function of the target chip.

39. The testing method according to any one of claims 27 to 38, further comprising:
in the process of controlling the at least some pins to be connected to the power supply module according to the sequence of connection, confirming whether the circuit function of the target chip is normal according to the reported information from the target chip.

40. A chip, comprising: a processor, configured to invoke a computer program from a memory and run the computer program, so that a device equipped with the chip executes the testing method according to any one of claims 27 to 39.

41. A computer-readable storage medium configured to store a computer program, wherein the computer program causes a computer to execute the testing method according to any one of claims 27 to 39.

42. A computer program product comprising computer program instructions, wherein the computer program instructions cause a computer to execute the testing method according to any one of claims 27 to 39.
